(19) Europäisches Patentamt
European Patent Office
Office européen des brevets

(11) **EP 3 163 296 B1**

(12) **EUROPEAN PATENT SPECIFICATION**

(45) Date of publication and mention
of the grant of the patent:
**18.07.2018 Bulletin 2018/29**

(51) Int Cl.:
**G01N 27/414** (2006.01)     **H01L 29/12** (2006.01)
**H01L 29/16** (2006.01)     **H01L 29/423** (2006.01)

(21) Application number: **15191899.2**

(22) Date of filing: **28.10.2015**

(54) **AN APPARATUS AND METHOD FOR SENSING AN ANALYTE, USING A GRAPHENE CHANNEL, QUANTUM DOTS AND ELECTROMAGNETIC RADIATION**

VORRICHTUNG UND VERFAHREN ZUM DETEKTIEREN EINES ANALYTS, MITTELS EINEM GRAPHENKANAL, QUANTENPUNKTE UND ELEKTROMAGNETISCHER STRAHLUNG

APPAREIL ET PROCEDE DE DETECTION D'UNE ANALYTE, UTILISANT UN CANAL EN GRAPHENE, DES POINTS QUANTIQUES ET DU RAYONNEMENT ELECTROMAGNETIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**03.05.2017 Bulletin 2017/18**

(73) Proprietor: **Nokia Technologies Oy**
**02610 Espoo (FI)**

(72) Inventors:
- **WHITE, Richard**
  **Huntingdon, Cambridgeshire PE28 9DY (GB)**
- **MALIK, Surama**
  **Cambridge, Cambridgeshire CB1 2FG (GB)**
- **ALLEN, Mark**
  **Cambridge, Cambridgeshire CB23 6BA (GB)**
- **BAILEY, Marc James Ashton**
  **Cambridge, Cambridgeshire CB4 3DD (GB)**

(74) Representative: **Swindell & Pearson Limited**
**48 Friar Gate**
**Derby DE1 1GY (GB)**

(56) References cited:
**WO-A1-2011/006677     WO-A1-2012/154726**
**WO-A1-2013/009961**

- XIAORU ZHANG ET AL: "A new photoelectrochemical aptasensor for the detection of thrombin based on functionalized graphene and CdSe nanoparticles multilayers", CHEMICAL COMMUNICATIONS - CHEMCOM, vol. 47, no. 17, 1 January 2011 (2011-01-01), page 4929, XP055265535, GB ISSN: 1359-7345, DOI: 10.1039/c1cc10830a
- WEN GUANGMING ET AL: "Biosensing strategy based on photocurrent quenching of quantum dots via energy resonance absorption", SCIENCE CHINA CHEMISTRY, ZHONGGUO KEXUE ZAZHISHE // SPRINGER, CN, vol. 58, no. 5, 15 March 2015 (2015-03-15), pages 879-884, XP035497906, ISSN: 1674-7291, DOI: 10.1007/S11426-014-5315-4 [retrieved on 2015-03-15]
- GERASIMOS KONSTANTATOS ET AL: "Hybrid graphene-quantum dot phototransistors with ultrahigh gain", NATURE NANOTECHNOLOGY, vol. 7, no. 6, 1 January 2012 (2012-01-01), pages 363-368, XP055039980, ISSN: 1748-3387, DOI: 10.1038/nnano.2012.60
- SHIXING CHEN ET AL: "Graphene-based nanoprobes for molecular diagnostics", THE ANALYST, vol. 140, no. 19, 1 January 2015 (2015-01-01), pages 6439-6451, XP055262440, GB ISSN: 0003-2654, DOI: 10.1039/C5AN00848D

• YOUNGHYE KIM ET AL: "Hybrid system of semiconductor and photosynthetic protein", NANOTECHNOLOGY, IOP, BRISTOL, GB, vol. 25, no. 34, 5 August 2014 (2014-08-05), page 342001, XP020268740, ISSN: 0957-4484, DOI: 10.1088/0957-4484/25/34/342001 [retrieved on 2014-08-05]

**Description**

TECHNOLOGICAL FIELD

Examples of the present disclosure relate to an apparatus and method for sensing. In particular they relate to an apparatus and method for sensing chemical analytes within a sample.

BACKGROUND

An apparatus for sensing may be configured to sense an analyte within a sample and produce an output indicative of the analyte. The analyte could be, for example, the presence of a chemical or group of chemicals within a sample. An electrical sensing apparatus may be arranged to produce an electrical output indicative of the analyte.

It is desirable to produce better sensing apparatus.

XIAORU ZHANG ET AL, CHEMICAL COMMUNICATIONS, vol. 47, no. 17, 1 January 2011, page 4929, XP055265535 discloses a new photoelectrochemical aptasensor for the detection of thrombin based on a functionalised graphene and CdSe nanoparticles multilayers.

WEN GUANGMING ET AL, SCIENCE CHINA CHEMISTRY, ZHONGGUO KEXUE ZAZHISHE/SPRINGER, CN, vol. 58, no. 5, 15 March 2015, pages 879-884, XP035497906 discloses a biosensing strategy based on photocurrent quenching of quantum dots via energy resonsance absorption.

GERASIMOS KONSTANTATOS ET AL, NATURE NANOTECHNOLOGY, vol. 7, no. 6, 1 January 2012, pages 363-368, XP055039980 discloses hybrid graphene-quantum dot phototransistors with ultrahigh gain. In this document quantum dots are used as gates on a graphene channel, the so-called photo-gating effect. One of the charge carriers from the photo-induced electron-hole pair remains trapped in the quantum dot layer, thus causing an electric field in the channel.

SHIXING CHEN ET AL, THE ANALYST, vol. 140, no. 19, 1 January 2015, pages 6439-6451, XP055262440 discloses graphene-bases nanoprobes for molecular diagnostics.

WO 2012/154726 discloses sensors based on single-walled carbon nanotubes and graphene which demonstrate extreme sensitivity as reflected in their electrical conductivity to gaseous molecules when exposed to in situ ultraviolet illumination during measurement of the analytes.

BRIEF SUMMARY

According to the invention an apparatus comprising a graphene field effect transistor according to claim 1 is provided. In some examples the response of the graphene field effect transistor may enable at least one analyte within the sample to be classified. According to the invention the graphene field effect transistor may comprise a ligand coupled to the quantum dots.

In some examples the apparatus may comprise a plurality of graphene field effect transistors. Different graphene field effect transistors may be configured to provide different responses to pulses of electromagnetic radiation when the apparatus is exposed to the sample. Different graphene field effect transistors may have at least one of; different types of quantum dots, different types of ligands, different thicknesses.

In some examples the apparatus may comprise an emitter configured to provide pulses of electromagnetic radiation. The emitter may be configured to enable at least one of; wavelength, power, duration of the pulse of electromagnetic radiation, pulse repetition frequency of the pulse of electromagnetic radiation to be controlled. The emitter may be configured to provide a first pulse of electromagnetic radiation at a first time to initiate a photochemical reaction and a second pulse of electromagnetic radiation at a second time to obtain a response from the graphene field effect transistor.

In some examples the apparatus may comprise a photodetector coupled to a gate electrode of a graphene field effect transistor within the apparatus.

In some examples the apparatus may comprise circuitry for monitoring parameters of the response of the graphene field effect transistor wherein the parameters comprise at least one of; amplitude, response time constant, recovery time, recovery time constant.

In some examples the apparatus may comprise at least one temperature sensor.

In some examples the apparatus may comprise at least one pressure sensor. According to various, but not necessarily all, examples of the disclosure there may be provided a sensing device comprising an apparatus as described above.

According to the invention a method according to claim 14 is provided. In some examples the responses of the graphene field effect transistor may enable at least one analyte within the sample to be classified.

In some examples the method may comprise positioning a plurality of graphene field effect transistors within the sample. Different graphene field effect transistors may be configured to provide different responses to pulses of electromagnetic radiation when the plurality of graphene field effect transistors are exposed to the sample. Different graphene field effect transistors may have at least one; of different types of quantum dots, different types of ligands, different thicknesses.

In some examples the method may comprise controlling at least one of; wavelength, power, duration of the pulse of electromagnetic radiation, pulse repetition frequency of the pulse of electromagnetic radiation.

In some examples the method may comprise providing a first pulse of electromagnetic radiation at a first time to initiate a photochemical reaction and a second pulse of electromagnetic radiation at a second time to obtain a response from the graphene field effect transistor.

In some examples the method may comprise providing a photodetector coupled to a gate electrode of the graphene field effect transistor.

In some examples the method may comprise monitoring parameters of the response of the graphene field effect transistor wherein the parameters comprise at least one of; amplitude, response time constant, recovery time, recovery time constant.

In some examples the method may comprise monitoring the temperature of the sample.

In some examples the method may comprise monitoring pressure within the sample.

BRIEF DESCRIPTION

For a better understanding of various examples that are useful for understanding the detailed description, reference will now be made by way of example only to the accompanying drawings in which:

Fig. 1 schematically illustrates an apparatus;
Fig. 2 schematically illustrates an apparatus;
Fig. 3 schematically illustrates an apparatus;
Fig. 4 illustrates a method;
Figs. 5A to 5C illustrate an example circuit and corresponding plots of current; and
Figs. 6A to 6D illustrate another example circuit and corresponding plots of current.

DETAILED DESCRIPTION

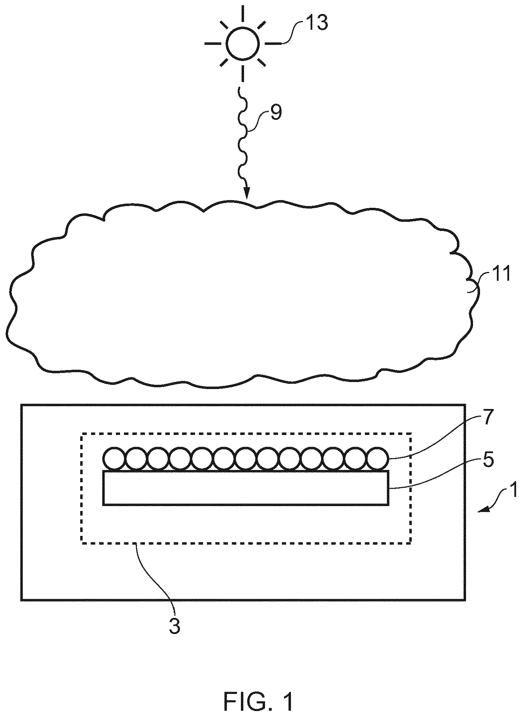

The invention is defined by independent claims 1 and 14. The figures illustrate example methods and apparatus 1. Fig. 1 schematically illustrates an apparatus 1 according to examples of the disclosure. The apparatus 1 comprises: a graphene field effect transistor 3 comprising quantum dots 7 coupled to a graphene channel 5; wherein the graphene field effect transistor 3 is configured to be illuminated by a pulse of electromagnetic radiation 9 and configured to be exposed to a sample 11 such that an output provided by the graphene field effect transistor 3, in response to the pulse of electromagnetic radiation 9, is dependent upon at least one analyte within the sample 11.

The apparatus 1 and methods may be used for sensing. In particular the apparatus 1 and methods may be used to sense analytes such as chemical analytes within a sample 11. The apparatus 1 may be an electronic apparatus which may be configured to provide an electronic output indicative of analytes within the sample 11. The electronic outputs may be processed to enable identification of chemical analytes within the sample. In some examples the apparatus 1, or a plurality of apparatus 1, may be provided within a sensing device.

Fig. 1 schematically illustrates an example apparatus 1. The example apparatus 1 comprises a graphene field effect transistor 3 (GFET). The GFET 3 is positioned within the apparatus 1 so that the GFET 3 may be illuminated by a pulse of electromagnetic radiation 9. The GFET 3 is positioned within the apparatus 1 so that when the apparatus 1 is exposed to the sample 11 chemicals within the sample may interact with the GFET 3.

The GFET 3 comprises a graphene channel 5. The graphene channel 5 may be provided between source and drain electrodes. The graphene within the graphene channel 5 may be provided in a thin layer. In some examples the graphene may have a thickness in the range of nanometers. In some examples the graphene may comprise an atomic monolayer. According to the invention and as shown in the example apparatus 1 of Fig. 1 quantum dots 7 are coupled to the graphene channel 5. In the example of Fig. 1 the quantum dots 7 are provided overlaying the graphene channel 5. In other examples the quantum dots 7 may be provided within and/or adjacent to the graphene channel 5.

The quantum dots 7 may comprise a nanocrystal in which there is quantum confinement in all three dimensions. The quantum dots 7 may comprise any suitable material. The material that is used for the quantum dots 7 may be chosen dependent upon the analytes that are to be detected, the parameters of the pulse of electromagnetic radiation 9 or any other suitable factor. In some examples the quantum dots 7 may comprise lead sulphide, cadmium sulphide, cadmium selenide, germanium, lead selenide, lead telluride or any other suitable material.

The quantum dots 7 may be positioned within the apparatus 1 so that the pulse of electromagnetic radiation 9 is incident on the quantum dots 7. The quantum dots 7 may convert the incident pulse of electromagnetic radiation 9 into electrical charge. The changes in charge distribution within the quantum dots 7 may be detected by the graphene channel 5 which produces a measureable electrical response.

In some examples the quantum dots 7 may generate excitons in response to the pulse of electromagnetic radiation 9. The excitons may be separated into electron-hole pairs and either the holes or electrons are removed by the graphene channel 5. This provides a doping effect in the graphene channel 5 so that the output of the GFET 3 is indicative of the charges generated by the quantum dots 7. According to the invention a ligand is provided within the GFET 3. The ligand is coupled to the quantum dots 7. The ligand may be provided on the surface of the quantum dots 7. The ligand may affect charge transfer between respective quantum dots 7 and/or between quantum dots 7 and the graphene channel 5. In some examples the ligand may be arranged within the quantum dots 7 to maintain a separation distance between quantum dots 7. Different ligands may be used to provide different distances between quantum dots 7.

In some examples the ligand may be configured to connect the quantum dots 7 to each other. In some examples the ligand may be configured to connect the quantum dots 7 to the graphene channel 5.

The ligand may comprise any suitable material. The material that is used for the ligand may be chosen dependent upon the analytes that are to be detected, the parameters of the pulse of electromagnetic radiation 9, the materials used for the quantum dots 7 or any other suitable factor. In some examples the ligand may comprise alkanedithiol, where the alkane comprises methane, ethane, propane, butane or any other suitable alkane, alkanethiol, amine such as butylamine, pyridine or any other suitable material.

The inventive apparatus 1 is configured to be illuminated by a pulse of electromagnetic radiation 9. The pulse of electromagnetic radiation 9 may be provided by an emitter 13. In some examples the emitter 13 may be part of the apparatus 1. In other examples the emitter 13 may be provided separate to the apparatus 1. A waveguide may be provided to direct the electromagnetic radiation 9 to the GFET 3.

The pulse of electromagnetic radiation 9 may comprise any suitable type of electromagnetic radiation. In some examples the pulse of electromagnetic radiation 9 may comprise visible light, ultraviolet (UV) and/or infra red (IR) wavelength light or any other suitable wavelengths.

In some examples the emitter 13 may be configured to enable parameters of the pulse of electromagnetic radiation 9 to be controlled. The parameters of the pulse of electromagnetic radiation 9 may comprise wavelength, power duration of the pulse of electromagnetic radiation 9, pulse repetition frequency of electromagnetic radiation 9 or any other suitable parameter. This may enable a pulse of electromagnetic radiation 9 having particular characteristics parameters to be used to illuminate the apparatus 1. The values that are chosen for the parameters may depend on factors such as the material within the quantum dots 7, the ligands used in the GFET, the analytes to be detected within the sample 11 or any other suitable factor.

In the example of Fig. 1 the apparatus 1 is exposed to a sample 11. The apparatus 1 is configured to be exposed to the sample 11 such that the pulse of electromagnetic radiation 9 passes through the sample 11 before it is incident on the apparatus 1. In some examples the apparatus 1 may be positioned within a sample 11. In some examples the sample 11 may flow over the apparatus 1.

It is to be appreciated that other arrangements of the apparatus 1 and emitter 13 could be used in other examples of the disclosure. For instance, in some examples the GFET 3 could be provided on a substrate which may be arranged to guide the pulse of electromagnetic radiation 9 from the emitter 13 onto the GFET 3. The substrate may comprise glass or any other suitable material. In such examples the pulse of electromagnetic radiation 9 would pass through the graphene channel 5 and then be incident on the quantum dots 7. In such examples the pulse of electromagnetic radiation 9 would not pass through the sample 11 before it is incident on the quantum dots 7. Such arrangements may be advantageous for use with samples 11 which are not transparent to the pulse of electromagnetic radiation 9.

The sample 11 may comprise a fluid such as a gas or liquid. The sample 11 may comprise one or more chemical analytes. The chemical analytes within the sample 11 may interact with the quantum dots 7 and/or ligands of the GFET. This interaction may affect the time taken for charge transfer between the quantum dots 7 and the graphene channel 5. The time taken for the charge transfer may increase or decrease depending on the materials and analytes involved.

When the apparatus 1 is illuminated with a pulse of electromagnetic radiation 9 the pulse causes a change in charge distribution within the quantum dots 7 which causes a response to be provided by the GFET 3. The profile of the response provided by the GFET 3 is dependent upon the time taken for charge transfer between the quantum dots 7 and the graphene channel 5. The profile of the response provided by the GFET 3 may comprise amplitude, response time constant, recovery time, recovery time constant or any other suitable parameter. When the apparatus 1 is exposed to a sample 11 the time taken for charge transfer between the quantum dots 7 and the graphene channel 5 is dependent upon whether or not any analytes have interacted with the quantum dots 7 and/or ligand. Therefore the profile of the response provided by the GFET 3 when an analyte is present is different to the response provided when the analyte is not present. This enables the response of the GFET 3 to be used to provide an indication of the presence of an analyte. According to the invention a ligand is provided within the GFET 3. The ligand is coupled to the quantum dots and configured to connect the quantum dots 7 to each other and/or to the graphene channel 5. The presence of the ligand may also affect the charge transfer between the quantum dots 7 and the graphene 7. As the charges are transferred from the quantum dots 7 to the ligand and then from the ligand to the graphene channel 5 the response which is provided by the GFET 3 is dependent upon the ligand which is used. According to the invention the analytes within the sample 11 interact with the quantum dots 9 and/or the ligand. This interaction may change the rate at which charge may be transferred between the quantum dots 7 and the graphene channel 5 and so may change the profile of the output provided by the GFET 3.

It is to be appreciated that the interaction of the chemical analytes with the quantum dots 7 and/or ligands may comprise any one or more of a plurality of different effects. For instance the absorption of a chemical by a layer of quantum dots 7 may change the dielectric environment, may cause a change in the separation between quantum dots 7, may cause a change in the band structure of the graphene, quantum dot 7 structure or any other suitable means. It is to be appreciated that it is not necessary to identify the mechanism which causes the change in the charge transfer as the presence of the analyte may be identified by the profile of the response of the GFET 3.

Therefore by using quantum dots 7 and/or ligands that interact with an analyte the apparatus 1 may be configured to sense the analyte. When a pulse of electromagnetic radiation 9 of known wavelength and duration is incident on the apparatus 1 the response which is provided by the GFET 3 will be dependent upon whether or not the analyte is present in the sample 11. The profile of the output provided by the GFET 3 can be processed to determine whether or not an analyte is present in the sample 11.

The use of the pulses of electromagnetic radiation 9 enables transient behaviour of the GFET 3 to be used to characterize analytes within samples 11. When the pulse of electromagnetic radiation 9 is initially incident on the apparatus 1 the current in the graphene channel 5 increases with time. The increase in the current $\Delta I_{DS}$ may be described by:

$$\Delta I_{DS} = \Delta I_1(1 - \exp(-t/\tau_1)) + \Delta I_2(1 - \exp(-t/\tau_2)),$$

The increase in the current $\Delta I_{DS}$ is dependent upon two relaxation times. The first relaxation time $\tau_1$ corresponds to charge transfer from the quantum dots 7 to the graphene channel 5. For example it may correspond to the transfer of holes from the quantum dots 7 to the graphene channel 5. The second relaxation time $\tau_2$ corresponds to charge transfer between the quantum dots 7. The first relaxation time may be shorter than the second relaxation time.

When the pulse of electromagnetic radiation 9 ends the current in the graphene channel 5 decreases with time. The decrease in current may be described by:

$$\Delta I_{DS} = \Delta I_3 \exp(-t/\tau_3) + \Delta I_4 \exp(-t/\tau_4)$$

The decrease in the current $\Delta I_{DS}$ is also dependent upon two relaxation times. The third relaxation time $\tau_3$ corresponds to charge transfer from the quantum dots 7 to the graphene channel 5. This may represent the lifetime of electrons in the quantum dots 7 before they transfer to the graphene channel 5. The fourth relaxation time $\tau_4$ corresponds to charge transfer between the quantum dots 7. The third relaxation time may be shorter than the fourth relaxation time.

Each of these different relaxation times may be dependent upon the materials used for quantum dots 7 and/or ligands. The relaxation times may be affected by the presence of an analyte and whether the analyte interacts with the quantum dots 1 and/or the ligands. The profile of the response which is provided by the GFET 3 is dependent on these relaxation times and so analysing these profiles may enable the analyte to be identified.

In some examples the apparatus 1 may be used to detect a plurality of analytes within a sample 11. For instance, a plurality of different analytes within a sample 11 may contribute a characteristic time constant to the output $\Delta I_{DS}$. In such examples the output provided by the GFET 3 would be the sum of these contributions. The relative concentration of the analyte or analytes present in the sample 11 may be determined by examining the component amplitudes in $\Delta I_{DS}$ for respective characteristic time constants associated with the analyte or analytes.

It is to be appreciated that this example of the response provided by the apparatus 1 may be used to enable data obtained from the apparatus 1 to be analysed. Other models may be used in other example apparatus 1. The models that may be used to enable data to be analysed may depend upon the mechanisms of charge transfer between the quantum dots 7 and the graphene channel 5 and/or the sequences of pulses of electromagnetic radiation 9 that are used to illuminate the apparatus 1 and/or any other suitable factors.

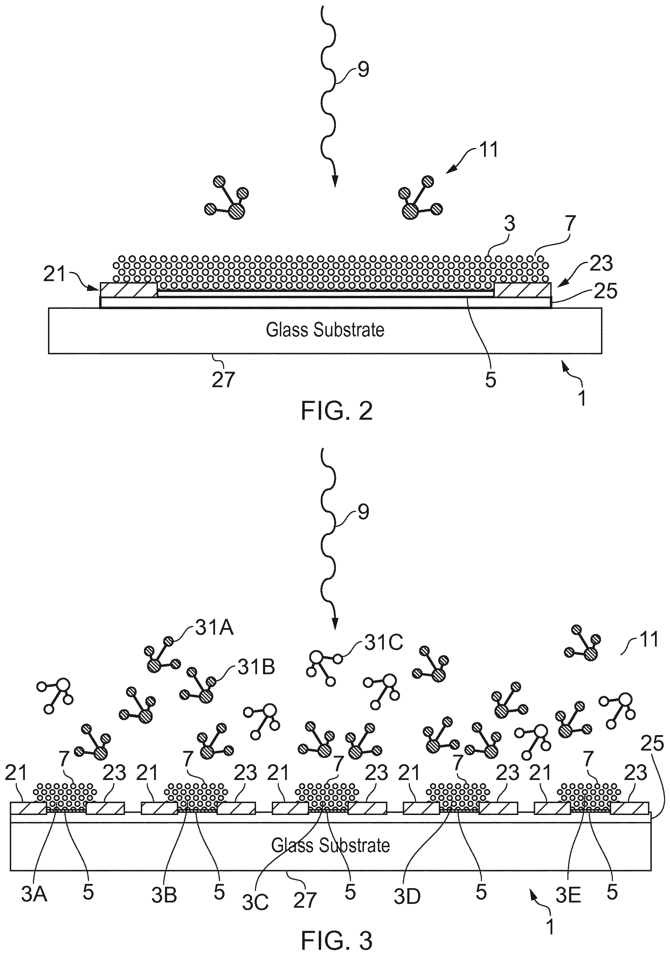

Fig. 2 schematically illustrates another example apparatus 1. The example apparatus 1 comprises a graphene field effect transistor 3 (GFET) which may be as described above. Corresponding reference numerals are used for corresponding features. The GFET 3 is also positioned within the apparatus 1 so that the GFET 3 may be illuminated by a pulse of electromagnetic radiation 9.

The GFET 3 in the example illustrated in Fig. 2 comprises a source electrode 21 and a drain electrode 23. The graphene channel 5 is provided between the source electrode 21 and the drain electrode 23 so that current flows from the source electrode 21 to the drain electrode 23 through the graphene channel 5.

The source and drain electrodes 21, 23 may comprise any suitable electrically conductive material. In some examples the source and drain electrodes 21, 23 may comprise a metal such as silver, copper or any other suitable material.

The source electrode 21, drain electrode 23 and the graphene channel 5 are provided on a dielectric layer 25. The dielectric layer 25 may comprise any suitable electrically insulating material.

In the example of Fig. 2 the GFET is provided on a glass substrate 27. The glass substrate 27 may be arranged to support the source electrode 21, drain electrode 23 and the graphene channel 5.

In the example of Fig. 2 the quantum dots 7 are provided in a layer overlaying the graphene channel 5. The quantum dots 7 may be provided in a very thin layer. In some examples the thickness of the quantum dot layer may be of the order of 10 to 500nm.

The quantum dots 7 are configured to perform the function of a gate electrode within the GFET 3 by controlling the flow of current between the source electrode 21 and the drain electrode 23 through the graphene channel 5. In the example of Fig. 2 the quantum dots 7 are configured so that the pulse of incident electromagnetic radiation 9 passes through the sample 11 and is incident on the quantum dots 7. The incident pulse of electromagnetic radiation 9 causes a change in the charge distribution within the quantum dots 7 which gates the graphene channel 5. The presence of the sample 11 may affect the charge transfer between the quantum dots 7 and the graphene 7 and may enable the GFET 3 to produce a response which enables an analyte or a plurality of analytes within the sample 11 to be classified.

The classification of one or more analytes within a sample 11 may enable a condition of the sample 11 or an entity associated with a sample to be identified. For instance, some diseases give rise to multiple chemical markers in the breath. By analysing a sample obtained from the breath of a patient a combination of markers may be identified by an apparatus 1.

Fig. 3 schematically illustrates another apparatus 1. The example apparatus 1 of Fig. 3 comprises a plurality of GFETs 3. In the example of Fig. 3 five GFETs are provided. It is to be appreciated that any number of GFETs could be provided in other example apparatus 1.

Each of the GFETs 3 in Fig. 3 comprises a source electrode 21, drain electrode 23 graphene channel 5 and layer of quantum dots 7 as described in relation to Fig. 2. In the example of Fig. 3 each of the GFETs 3 are provided on the same glass substrate 27 and the same layer of dielectric 25. The GFETS 3 may be provided so that each of the GFETs 3 may be individually addressed and an individual output may be obtained from each of the GFETs 3.

In the example of Fig. 3 the plurality of GFETs 3 are arranged so that they are all exposed to the same sample 11. The sample 11 comprises a plurality of different analytes 31A, 31B, 31C. The plurality of GFETs 3 may be arranged so that different GFETs 3 within the apparatus provide different responses to the same sample 11. For instance, different GFETs 3 within the apparatus 1 may enable different analytes 31A, 31B, 31C to be detected. The different responses may be used to analyse the sample 11. The different responses may enable one or more of the analytes 31A, 31B, 31C to be identified.

To enable different GFETs 3 within the apparatus 1 to provide different responses different GFETs 3 may be configured with different arrangements of quantum dots 7 and/or ligands. For instance in some examples different GFETs 3 may comprise quantum dots 7 of different materials or different combinations of materials. In some examples the layers of quantum dots 7 may have different thicknesses. GFETs 3 having layers of quantum dots 7 with different thicknesses may comprise the same material for the quantum dots 7 or different materials and/or combinations of materials. In some examples different GFETs 3 may comprise different ligands or combinations of ligands.

In the particular example of Fig. 3 each of the GFETs 3 is arranged to provide a different response profile in response to the sample 11. In some examples two or more GFETs 3 may be arranged to detect the same analyte but may have different sensitivities to the same analyte. This may enable a quantitative analysis of the presence of an analyte within the sample 11.

In the particular example of Fig. 3 the first GFET 3A comprises quantum dots 7 of material A and a ligand comprising material X. The second GFET 3B comprises quantum dots 7 of material B and a ligand comprising material X so that the first and second GFETs 3A, 3B comprise different types of quantum dots 7 but the same ligand. The third GFET 3C comprises quantum dots 7 of material A and a ligand comprising material Y. The fourth GFET 3D comprises quantum dots 7 of material A and a ligand comprising material Z. That is, the first, third and fourth GFETs 3A, 3C 3D comprise the same types of quantum dots 7 but each have different ligands. The fifth GFET 3D comprises quantum dots 7 of material A and a ligand comprising a combination of material X and material Z so that the fifth GFET 3E has a different type of ligand to the first, third and fourth GFETs 3A, 3C, 3D.

It is to be appreciated that other variations in the arrangements of the ligands and/or quantum dots 7 may be used in other examples of the disclosure. In some examples two of more layers of quantum dots 7 may be provided in a single GFET 3. The different layers of quantum dots could have the same or different ligands. In such examples charge must be transferred from the first layer of quantum dots to the second layer of quantum dots and any other subsequent layers before it is transferred to the graphene channel 5. This causes the profile of the response of the GEFT 3 to be dependent on the rate of the transfer of charges between the layers of quantum dots 7 and whether or not the presence of any analytes have affected this charge transfer.

The variations in the arrangements of the ligands and/or quantum dots 7 may enable outputs having different profiles to be provided by different GFETs 3. The different outputs may be dependent on the analytes within the sample 11. The plurality of different outputs may enable information indicative of the analytes within the sample 11 to be obtained.

Any suitable method may be used to classify the one or more analytes within a sample 11. In examples a data vector may be generated. The data vector may comprise a plurality of different dimensions where the different dimensions correspond to different parameters of the response of the GFET 3. In some examples the different parameters could comprise the different time constants, the magnitude of the response, time lags within the response or any other suitable parameters. The obtained data vector may then be processed to enable the data to be classified. Any suitable technique may be used to process the data vector. In some examples use techniques such as principal components analysis, linear or quadratic discriminant analysis, or any other suitable technique may be used to project the original data vector into a reduced dimension coordinate system to enable patterns or correlations to be identified.

In the example of Fig. 3 different responses are obtained by providing GFETs 3 with different arrangements of ligands and/or quantum dots 7. In other examples other means may be used to obtain different response. For instance, in some examples different GFETs 3 could be illuminated with different pulses of electromagnetic radiation 9. The pulses of electromagnetic radiation 9 may induce photochemical reactions of the sample 11 with the quantum dots 7 and/or ligands such that varying the parameters of the pulses of electromagnetic radiation 9 enables a different response to be provided. The different pulses of electromagnetic radiation 9 could have different wavelengths, power or durations.

The apparatus 1 may be calibrated so that analytes can be identified easily. In some examples the apparatus 1 could be calibrated by using one or more samples 11 of known composition of chemical analytes to obtain one or more signature responses. The composition of a test sample 11 can then be analysed by comparing an output obtained with the test sample 11 with the output obtained by a calibration sample 11.

It is to be appreciated that in some examples the apparatus 1 may comprise additional components that are not illustrated in Figs. 1 to 3. For instance, in some examples the apparatus 1 may comprise circuitry which may enable parameters of the response of the GFET 3 to be monitored. The circuitry may enable parameters such as amplitude, response time constant, recovery time, recovery time constant or any other suitable parameter to be monitored. The monitoring of the response of the GFET 3 may enable analytes within the sample 11 to be identified.

In some examples the apparatus 1 may comprise additional sensors that may be arranged to sense other parameters that could affect the output of the GFET 3. The outputs of the additional sensors may be used to correct the output of the GFET 3 for variations in these parameters. In some examples the apparatus 1 may comprise a temperature sensor which may be configured to determine the temperature of the sample 11 and/or the apparatus 1. In some examples a plurality of temperature sensors may be provided. The plurality of temperature sensors may be provided in different positions within the apparatus 1. For instance a first temperature sensor may be provided within the gas inlet system, a second temperature sensor may be provided within an array of the GFETs 3 and a third temperature sensor may be provided in an exhaust outlet.

In some examples a pressure sensor, such as a gas pressure sensor may be provided to monitor the pressure within the sample 11. In some examples the apparatus 1 may comprise a strain sensor which may be configured to detect any deformation of the apparatus 1.

In some examples the apparatus 1 may comprise one or more filters. The filters may comprise any means which may be configured to prepare the sample 11 before it is incident on the GFET 3.

In some examples the filters may comprise chromatography matrices or any other suitable filters. The chromatography matrices may be configured so that only certain chemical species from the sample 11 are incident on the GFETs 3.

In some examples the one or more filters may be configured to remove particles from the sample which could block the pulse of electromagnetic radiation 9 from the GFET 3. For instance particles such as PM10 and PM25 are commonly found in car exhaust fumes and may physically block light from reaching the GFETs 3.

In some examples the apparatus 1 may comprise means for splitting the sample into two or more different component samples. The different component samples may then be analysed under different conditions. For instance in some examples the splitter may be configured to split the sample into two different component samples. The first component sample may be analysed as a humid sample. The humid sample may comprise water mixed in with the sample. The second component sample may be dried by removing the water through condensation or passing the second component sample through a desiccant or any other suitable means. The second component may then be analysed as a dried sample. Both of the samples may be analysed by providing pulses of electromagnetic radiation 9 when the apparatus 1 is positioned in the respective component samples. The two different results can be compared to determine the effect of water on the performance of the apparatus 1. In some examples a mathematical calibration system can be developed by exposing control apparatus 1 to gases of known humidity to model the effect of changing concentration of water within the sample 11.

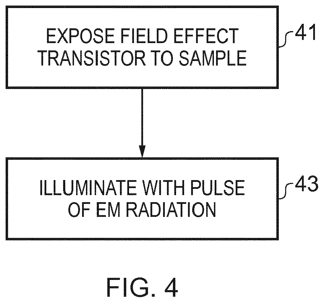

Fig. 4 illustrates a method. The method may be used to enable a sample 11 to be analysed. The method may be used to enable an apparatus 1 such as the example apparatus 1 of Figs. 1 to 3 to be used to analyse a sample.

The method comprises, at block 41, exposing a graphene field effect transistor 3 to a sample wherein the graphene field effect transistor 3 comprises quantum dots 7 coupled to a graphene channel 5. The method also comprises, at block 43, illuminating the graphene field effect transistor 3 by a pulse of electromagnetic radiation 9 such that an output provided by the graphene field effect transistor 3, in response to the pulse of electromagnetic radiation 9, is dependent upon at least one analyte within the sample 11.

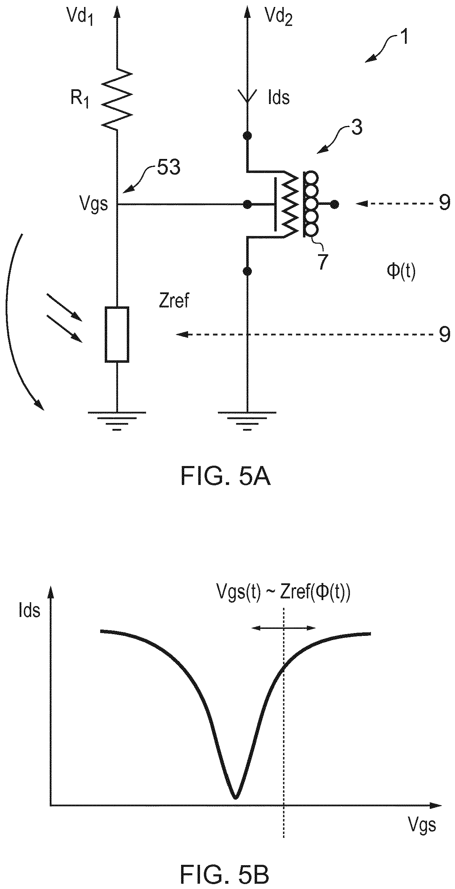

Fig. 5A illustrates a circuit of an example apparatus 1. The circuit enables synchronization of the response to the GFET 3 to the pulse of electromagnetic radiation 9 which may enable the time constants of the response of the GFET 3 to be measured.

The example circuit of Fig. 5A comprises a GFET 3 with a layer of quantum dots 7 where the quantum dots 7 function as a gate electrode. The GFET 3 is coupled to biasing circuitry 53. The biasing circuitry may comprise any means which may be arranged to set the back gate voltage $V_{gs}$ of the GFET 3. In the example of Fig. 5A the biasing circuitry 53 comprises two impedance components. The first impedance component is a resistor $R_1$ and the second impedance component is a light-sensitive reference component $Z_{ref}$.

The light-sensitive reference component $Z_{ref}$ may comprise any means which enables the back gate voltage $V_{gs}$ to be modulated in response to an incident pulse of light or other suitable electromagnetic radiation 9. The light-sensitive reference component $Z_{ref}$ may be configured to provide an offset level or peak in the drain current which is dependent upon an incident pulse of electromagnetic radiation 9. The light-sensitive reference component $Z_{ref}$ may be configured to have a faster response to a pulse of electromagnetic radiation 9 than the quantum dots 7 so that the light-sensitive reference component $Z_{ref}$ enables accurate synchronization for measurements of time constants of the response of the GFET 3.

In the example of Fig. 5A the light-sensitive reference component $Z_{ref}$ comprises a high speed photodetector 51. The high speed photo detector 51 may comprise any suitable component such as a photodiode.

The biasing circuitry 53 is arranged so that the current through the graphene channel 5 is determined by both the charge distribution in the quantum dots 7 and also modulation of the back gate voltage $V_{gs}$ caused by the light-sensitive reference component $Z_{ref}$.

Fig. 5B is a plot of current $I_{ds}$ though the graphene channel 5 against back gate voltage $V_{gs}$. The plot shows the shift in bias point as a function of modulation of the back gate voltage $V_{gs}$. When back gate voltage $V_{gs}$ is below the Dirac point the dominant conduction is p-type (holes) and when the back gate voltage $V_{gs}$ is above the Dirac point the dominant conduction is n-type (electrons). The plot of Fig. 5B shows a shift in the transfer curve when the GFET 3 is biased to exhibit n-type doping. P-type doping may be provided in other examples.

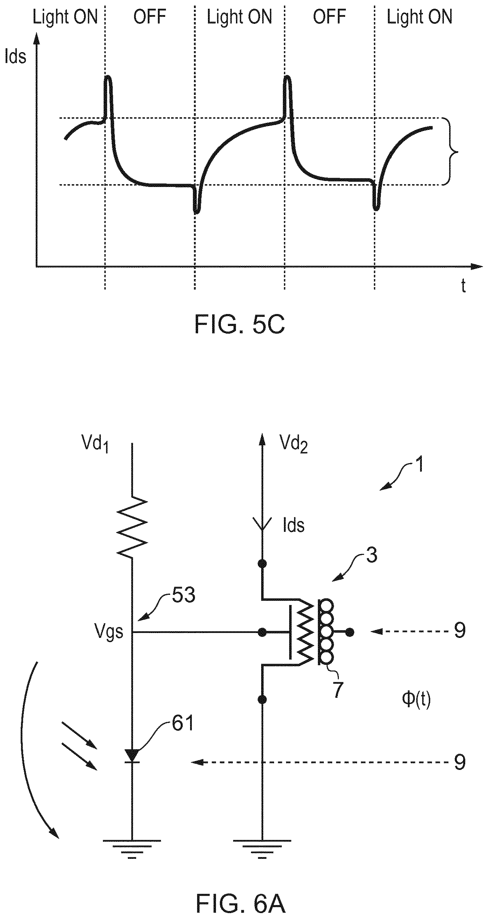

Fig. 5C is a plot of current though the graphene channel 5 against time as the pulse of electromagnetic radiation 9 is pulsed on and off. The light-sensitive reference component $Z_{ref}$ may be configured so that the impedance only changes when there is a change in the flux of light or other incident electromagnetic radiation 9.

In the example of Fig. 5C the resistance of the light-sensitive reference component $Z_{ref}$ decreases momentarily when the light is turned on and returns to a base level within a time much shorter than the time constants of the quantum dots 7 in the GFET 3. Similarly the resistance of the light-sensitive reference component $Z_{ref}$ increases momentarily when the light is turned off. This modulation of light-sensitive reference component $Z_{ref}$ causes a change in the back gate voltage $V_{gs}$. That is when the light is turned on there is momentary decrease in the back gate voltage $V_{gs}$ and when the light is turned off there is a momentary increase. The momentary increase lasts for a period of time which is shorter than the time constants of the charge transfer through the quantum dots 7. This causes a momentary offset in the current through the graphene channel 5. This momentary offset in the current through the graphene channel 5 provides a synchronization signal.

In the example of Figs. 5A to 5C the current increases when the light is turned off and decreases when the light on. It is to be appreciated that if the GFET 3 is biased into the p-doped region rather than n-doped region as shown in Fig. 5B then the current could decrease when the light is turned off and increase when the light is turned on.

Fig. 6A illustrates another example circuit. The circuit of Fig. 6A is similar to the circuit of Fig. 5A and corresponding reference numerals are used for corresponding features. In Fig. 6A the light-sensitive reference component $Z_{ref}$ comprises a photodiode 61.

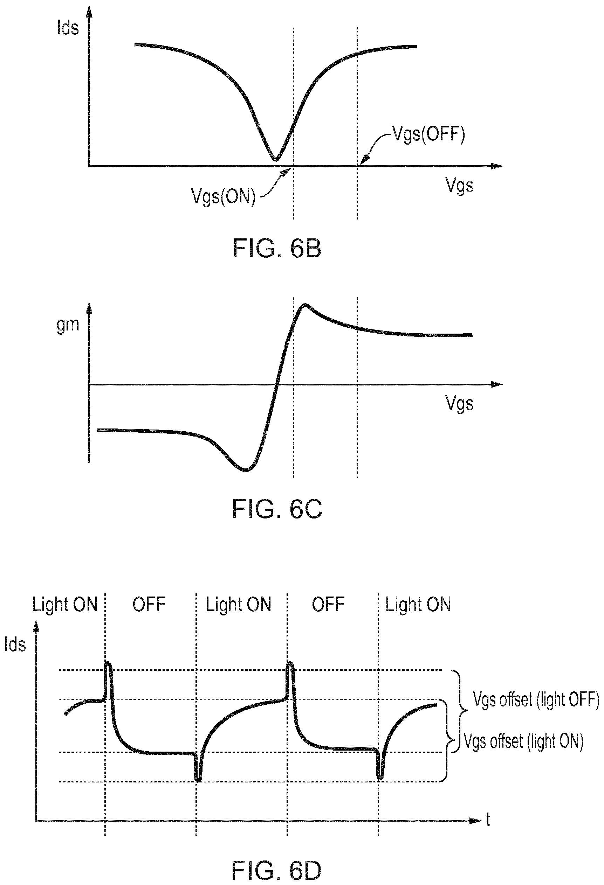

Fig. 6B is a plot of back gate voltage and current though the graphene channel 5. The plot shows the shifts in bias point as a function of modulation of the back gate voltage $V_{gs}$ due to the photodiode 61. The plot shows the two different operating points when the light is turned on compared to when the light is turned off.

Fig. 6C is a plot of transconductance $g_m$ of the GFET 3 against the back gate voltage $V_{gs}$. The transconductance $g_m$ may be optimised so that the rising or falling edges of the current exhibit the same amplification or so that one is amplified more than the other.

Fig. 6D is a plot of current though the graphene channel 5 against time as the pulse of electromagnetic radiation 9 is pulsed on and off. In the example of Figs. 6A to 6D the photodiode 61 causes an offset in the back gate voltage $V_{gs}$

for the entire duration of the pulse of electromagnetic radiation 9.

When the light is turned off there is no incident pulse of electromagnetic radiation 9 on the photo diode 61. The back gate voltage $V_{gs}$ will be higher and the corresponding offset current will also be higher. When the light is then turned on the gating of the graphene channel 5 by the quantum dots 7 causes the current though the graphene channel 5 to decrease.

When the light is turned on there is a pulse of electromagnetic radiation 9 incident on the photo diode 61. The back gate voltage $V_{gs}$ will be lower and the corresponding offset current will also be lower. When the light is then turned off the gating of the graphene channel 5 by the quantum dots 7 causes the current though the graphene channel 5 to increase.

In the examples of Figs. 5A to 6D the biasing circuitry 53 is coupled to a gate electrode of the GFET 3. Only one GFET 3 is shown in Figs. 5A and 6A however it is to be appreciated that biasing circuitry 53 could be provided in apparatus 1 comprising a plurality of GFETs 3. In some examples the plurality of GFETs 3 may share a common gate electrode and the biasing circuitry 53 may be coupled to the shared electrode. In other examples each GFET 3 may have an individually controlled back gate electrode and each of these electrodes could be coupled to different biasing circuitry 53.

In the above described examples the pulse of electromagnetic radiation 9 activates the charge transfer from the quantum dots 7 to the graphene channel so that the chemical effect of the sample 11 can be identified. In some examples the pulse of electromagnetic radiation 9 may induce photochemical reaction of the chemicals within the sample 11. For instance, the emitter 13 may be configured to provide a first pulse of electromagnetic radiation 9 at a first time and a second pulse of electromagnetic radiation 9 at a second time. The first pulse of electromagnetic radiation 9 may initiate a photochemical reaction within the sample 11. The second pulse of electromagnetic radiation 9 may be used to obtain a response from the GFET 3 which provides an indication of the effect of the photochemical reaction with the sample 11.

The nature of the induced photochemical reactions is dependent upon the composition of the sample 11, the wavelength, power and duration of the pulse of electromagnetic radiation 9 and the materials used for quantum dots 7 and/or ligands. Therefore the output provided by the GFETs 3 may be dependent on whether or not the pulse of electromagnetic radiation 9 induces a photochemical reaction. This may enable further information about the sample 11 to be obtained using apparatus 1 and methods as described above.

In some examples the apparatus 1 and emitter 13 may be configured so that all of the GFETs 3 within an apparatus 1 measure the response after a photochemical reaction has been induced. In other examples the apparatus 1 and emitter 13 could be arranged so that the photochemically activated sample 11 is only incident on a subset of the GFETs 3. This may enable the apparatus 1 to be used to obtain information about the non-activated sample 11 and the results of the photochemical reaction within the sample 11.

In some examples the sample 11 may be exposed to the electromagnetic radiation 9 before the sample 11 is provided to the apparatus 1. This may enable the end products of the photochemical reactions to be identified. In some examples a reactant may be added to the sample 11 where the reactant is known to photochemically react with an analyte to produce an end product which interacts the with quantum dots 7 and/or ligands of the apparatus 1.

In some examples different GFETs 3 within an apparatus 1 may be illuminated at different times. If the sample 11 is flowing over the apparatus 1 this may increase the time that the sample 11 is exposed to the electromagnetic radiation 9 as it moves to successive GFETs 3. This may enable the sample 11 to be analysed at different times of exposure. The initiation of photochemical reactions and the measurements obtained at different time points may enable additional information to be obtained from a sample 11. The information that can be obtained through the use of the photochemical reactions may depend on the analytes within the sample 11, the nature of the ligands and/or the quantum dots 7, and time allocated to measuring the sample 11 or any other suitable factor.

In some examples the GFET 3 may be initially illuminated with a first pulse of electromagnetic radiation 9 which has a first wavelength. The first wavelength may be such that it does not activate charge transfer within the quantum dots 7 but it does activate a photochemical reaction within the sample 11. The GFET 3 may then be illuminated with a second pulse of electromagnetic radiation 9 which has a second wavelength. The second wavelength may be different to the first wavelength such that the second pulse of electromagnetic radiation 9 activates charge transfer within the quantum dots 7 and enables a response to be provided by the GFET 3. This may enable the photochemical reaction to be induced separately to the activation of the GFETs 3.

The apparatus 1 may be configured so that the apparatus 1 can be cleaned after use. This may enable the same apparatus 1 to be used more than once. In some examples the apparatus 1 may be configured to be cleaned by streaming a carrier gas through the apparatus 1 to dilute out remaining traces of the sample 11. In some examples the apparatus 1 may be cleaned by operating an emitter 13 at a high intensity so that any adsorbed species are excited to aid desorption. In some examples a heater may be used to increase the temperature of the apparatus 1 and improve the efficiency of the heating.

Examples of the disclosure provide an apparatus 1 that may be used to sense analytes within a sample 11.

The apparatus 1 may be used to obtain sufficient data to enable chemicals to be classified without the need for chemical sampling.

In this description the term "coupled" means operationally coupled. Any number of components may be provided between coupled elements, including zero components.

The term "comprise" is used in this document with an inclusive not an exclusive meaning. That is any reference to X comprising Y indicates that X may comprise only one Y or may comprise more than one Y. If it is intended to use "comprise" with an exclusive meaning then it will be made clear in the context by referring to "comprising only one..." or by using "consisting".

In this brief description, reference has been made to various examples. The description of features or functions in relation to an example indicates that those features or functions are present in that example. The use of the term "example" or "for example" or "may" in the text denotes, whether explicitly stated or not, that such features or functions are present in at least the described example, whether described as an example or not, and that they can be, but are not necessarily, present in some of or all other examples. Thus "example", "for example" or "may" refers to a particular instance in a class of examples. A property of the instance can be a property of only that instance or a property of the class or a property of a subclass of the class that includes some but not all of the instances in the class. It is therefore implicitly disclosed that a features described with reference to one example but not with reference to another example, can where possible be used in that other example but does not necessarily have to be used in that other example.

Although examples of the disclosure have been described in the preceding paragraphs with reference to various examples, it should be appreciated that modifications to the examples given can be made without departing from the scope of the invention as claimed. For instance in some examples the apparatus 1 may be configured so that a user can add or remove ligands from the quantum dots 7. This may enable a user to change the responsivity of the apparatus 1. This may enable a user to change the chemicals and/or the quantities of the chemicals that are detected by the apparatus 1.

Features described in the preceding description may be used in combinations other than the combinations explicitly described.

Although functions have been described with reference to certain features, those functions may be performable by other features whether described or not.

Although features have been described with reference to certain examples, those features may also be present in other embodiments whether described or not.

Whilst endeavoring in the foregoing specification to draw attention to those features of the invention believed to be of particular importance it should be understood that the invention is defined by the independent claims.

**Claims**

1. An apparatus (1) comprising:
   a graphene field effect transistor (3) comprising:

   a source electrode (21) and a drain electrode (23), wherein a graphene channel (5) is provided between the source electrode (21) and the drain electrode (23);
   quantum dots (7) coupled to the graphene channel (5), wherein the quantum dots (7) are configured to perform the function of a gate electrode, by controlling the flow of current through the graphene channel between the source and the drain electrodes;
   a ligand coupled to the quantum dots (7);
   wherein the graphene field effect transistor (3) is configured to be illuminated by a pulse of electromagnetic radiation (9) and configured to be exposed to a sample (11) comprising one or more chemical analytes, wherein the one or more chemical analytes interacts with the quantum dots and/or the ligand, such that the electronic output provided by the graphene field effect transistor (3), in response to the pulse of electromagnetic radiation (9), is dependent upon at least one of the one or more chemical analytes within the sample (11).

2. An apparatus (1) as claimed in any preceding claim wherein the electronic output provided by the graphene field effect transistor (3) in response to the pulse of electromagnetic radiation (9) enables at least one of the one or more chemical analytes within the sample (11) to be identified.

3. An apparatus (1) as claimed in any preceding claim comprising a plurality of graphene field effect transistors (3).

4. An apparatus (1) as claimed in claim 3 wherein different graphene field effect transistors (3) are configured to provide different responses to pulses of electromagnetic radiation (9) when the apparatus is exposed to the sample (11).

5. An apparatus (1) as claimed in any of claims 3 to 4 wherein different graphene field effect transistors (3) have at least one of; different types of quantum dots, different types of ligands, different thicknesses.

6. An apparatus (1) as claimed in any preceding claim comprising an emitter (13) configured to provide pulses of electromagnetic radiation (9).

7. An apparatus (1) as claimed in claim 6 wherein the emitter (13) is configured to enable at least one of; wavelength, power, duration of the pulse of electromagnetic radiation (9), pulse repetition frequency of the pulse of electromagnetic radiation (9) to be controlled.

8. An apparatus (1) as claimed in any of claims 6 to 7 wherein the emitter (13) is configured to provide a first pulse of electromagnetic radiation (9) which has a first wavelength at a first time to initiate a photochemical reaction, and a second pulse of electromagnetic radiation (9) which has a second wavelength different from the first wavelength at a second time to obtain a response from the graphene field effect transistor (3).

9. An apparatus (1) as claimed in any preceding claim comprising a photodetector (51) coupled to a gate electrode of a graphene field effect transistor (3) within the apparatus (1).

10. An apparatus (1) as claimed in any preceding claim comprising circuitry for monitoring parameters of the response of the graphene field effect transistor (3) wherein the parameters comprise at least one of; amplitude, response time constant, recovery time, recovery time constant.

11. An apparatus (1) as claimed in any preceding claim comprising at least one temperature sensor.

12. An apparatus (1) as claimed in any preceding claim comprising at least one pressure sensor.

13. A sensing device comprising an apparatus (1) as claimed in any of claims 1 to 12.

14. A method comprising:
exposing a graphene field effect transistor (3) to a sample (11) comprising one or more chemical analytes, wherein the graphene field effect transistor (3) comprises a source electrode (21) and a drain electrode (23), wherein a graphene channel (5) is provided between the source electrode (21) and the drain electrode (23), wherein quantum dots (7) are coupled to the graphene channel (5), wherein the quantum dots (7) are configured to perform the function of a gate electrode, by controlling the flow of current through the graphene channel between the source and the drain electrodes; and wherein a ligand is coupled to the quantum dots;
wherein the one or more chemical analytes interacts with the quantum dots and/or the ligand; illuminating the graphene field effect transistor (3) by a pulse of electromagnetic radiation (9) such that the electronic output provided by the graphene field effect transistor (3), in response to the pulse of electromagnetic radiation (9), is dependent upon at least one of the one or more chemical analytes within the sample (11).

**Patentansprüche**

1. Einrichtung (1), die Folgendes umfasst:
einen Graphen-Feldeffekttransistor (3), der Folgendes umfasst:

eine Source-Elektrode (21) und eine Drain-Elektrode (23), wobei ein Graphenkanal (5) zwischen der Source-Elektrode (21) und der Drain-Elektrode (23) bereitgestellt ist;
Quantenpunkte (7), die mit dem Graphenkanal (5) gekoppelt sind, wobei die Quantenpunkte (7) dazu konfiguriert sind, die Funktion einer Gate-Elektrode durchzuführen, indem der Stromfluss durch den Graphenkanal zwischen der Source- und der Drain-Elektrode gesteuert wird;
einen Liganden, der mit den Quantenpunkten (7) gekoppelt ist;
wobei der Graphen-Feldeffekttransistor (3) dazu konfiguriert ist, durch einen Puls elektromagnetischer Strahlung (9) beleuchtet zu werden, und dazu konfiguriert ist, einer Probe (11) ausgesetzt zu werden, die einen oder mehrere chemische Analyten umfasst, wobei der eine oder die mehreren chemischen Analyten mit den Quantenpunkten und/oder dem Liganden interagieren, sodass die elektronische Ausgabe, die durch den Graphen-Feldeffekttransistor (3) als Reaktion auf den Puls elektromagnetischer Strahlung (9) bereitgestellt wird, von wenigstens einem des einen oder der mehreren chemischen Analyten innerhalb der Probe (11) abhängt.

2. Einrichtung (1) nach einem vorhergehenden Anspruch, wobei die elektronische Ausgabe, die durch den Graphen-Feldeffekttransistor (3) als Reaktion auf den Puls elektromagnetischer Strahlung (9) bereitgestellt wird, ermöglicht, dass wenigstens einer des einen oder der mehreren chemischen Analyten innerhalb der Probe (11) identifiziert wird.

3. Einrichtung (1) nach einem vorhergehenden Anspruch, die mehrere Graphen-Feldeffekttransistoren (3) umfasst.

4. Einrichtung (1) nach Anspruch 3, wobei unterschiedliche Graphen-Feldeffekttransistoren (3) dazu konfiguriert sind, unterschiedliche Reaktionen auf Pulse elektromagnetischer Strahlung (9) bereitzustellen, wenn die Einrichtung der Probe (11) ausgesetzt wird.

5. Einrichtung (1) nach einem der Ansprüche 3 bis 4, wobei unterschiedliche Graphen-Feldeffekttransistoren (3) wenigstens eines von Folgendem aufweisen: unterschiedliche Typen von Quantenpunkten, unterschiedliche Typen von Liganden, unterschiedliche Dicken.

6. Einrichtung (1) nach einem vorhergehenden Anspruch, die einen Emitter (13) umfasst, der dazu konfiguriert ist, Pulse elektromagnetischer Strahlung (9) bereitzustellen.

7. Einrichtung (1) nach Anspruch 6, wobei der Emitter (13) dazu konfiguriert ist, zu ermöglichen, dass wenigstens eines von Folgendem gesteuert wird: Wellenlänge, Leistung, Dauer der Pulse elektromagnetischer Strahlung (9), Pulswiederholfrequenz der Pulse elektromagnetischer Strahlung (9).

8. Einrichtung (1) nach einem der Ansprüche 6 bis 7, wobei der Emitter (13) dazu konfiguriert ist, einen ersten Puls elektromagnetischer Strahlung (9), der eine erste Wellenlänge aufweist, bei einer ersten Zeit zum Initiieren einer fotochemischen Reaktion und einen zweiten Puls elektromagnetischer Strahlung (9), der eine von der ersten Wellenlänge verschiedene zweite Wellenlänge aufweist, bei einer zweiten Zeit zum Erhalten einer Reaktion von dem Graphen-Feldeffekttransistor (3) bereitzustellen.

9. Einrichtung (1) nach einem vorhergehenden Anspruch, die einen Fotodetektor (51) umfasst, der mit einer Gate-Elektrode eines Graphen-Feldeffekttransistors (3) innerhalb der Einrichtung (1) gekoppelt ist.

10. Einrichtung (1) nach einem vorhergehenden Anspruch, die eine Schaltungsanordnung zum Überwachen von Parametern der Reaktion des Graphen-Feldeffekttransistors (3) umfasst, wobei die Parameter wenigstens eines von Folgendem umfassen: Amplitude, Reaktionszeitkonstante, Erholungszeit, Erholungszeitkonstante.

11. Einrichtung (1) nach einem vorhergehenden Anspruch, die wenigstens einen Temperatursensor umfasst.

12. Einrichtung (1) nach einem vorhergehenden Anspruch, die wenigstens einen Drucksensor umfasst.

13. Erfassungsvorrichtung, die eine Einrichtung (1) nach einem der Ansprüche 1 bis 12 umfasst.

14. Verfahren, das Folgendes umfasst:

Aussetzen eines Graphen-Feldeffekttransistors (3) gegenüber einer Probe (11), die einen oder mehrere chemische Analyten umfasst, wobei der Graphen-Feldeffekttransistor (3) eine Source-Elektrode (21) und eine Drain-Elektrode (23) umfasst, wobei ein Graphenkanal (5) zwischen der Source-Elektrode (21) und der Drain-Elektrode (23) bereitgestellt ist, wobei Quantenpunkte (7) mit dem Graphenkanal (5) gekoppelt sind, wobei die Quantenpunkte (7) dazu konfiguriert sind, die Funktion einer Gate-Elektrode durchzuführen, indem der Stromfluss durch den Graphenkanal zwischen der Source- und der Drain-Elektrode gesteuert wird; und wobei ein Ligand mit den Quantenpunkten gekoppelt ist; wobei der eine oder die mehreren chemischen Analyten mit den Quantenpunkten und/oder dem Liganden interagieren; Beleuchten des Graphen-Feldeffekttransistors (3) durch einen Puls elektromagnetischer Strahlung (9), sodass die elektronische Ausgabe, die durch den Graphen-Feldeffekttransistor (3) als Reaktion auf den Puls elektromagnetischer Strahlung (9) bereitgestellt wird, von wenigstens einem des einen oder der mehreren chemischen Analyten innerhalb der Probe (11) abhängt.

**Revendications**

1. Appareil (1) comprenant :
un transistor à effet de champ à base de graphène (3) comprenant :

une électrode source (21) et une électrode drain (23), dans lequel un canal de graphène (5) est disposé entre l'électrode source (21) et l'électrode drain (23) ;
des points quantiques (7) couplés au canal de graphène (5), dans lequel les points quantiques (7) sont configurés pour réaliser la fonction d'une électrode grille en régulant la circulation d'un courant à travers le canal de graphène entre l'électrode source et l'électrode drain ;
un ligand couplé aux points quantiques (7) ;
dans lequel le transistor à effet de champ à base de graphène (3) est configuré pour être éclairé par une impulsion de rayonnement électromagnétique (9) et configuré pour être exposé à un échantillon (11) comprenant un ou plusieurs analytes chimiques, dans lequel le ou les analytes chimiques interagissent avec les points quantiques et/ou le ligand de telle sorte que la sortie électronique fournie par le transistor à effet de champ à base de graphène (3), à la suite de l'impulsion de rayonnement électromagnétique (9), soit dépendante d'un analyte chimique et/ou de plusieurs analytes chimiques dans l'échantillon (11).

2. Appareil (1) selon l'une quelconque des revendications précédentes, dans lequel la sortie électronique fournie par le transistor à effet de champ à base de graphène (3), à la suite de l'impulsion de rayonnement électromagnétique (9), permet l'identification d'un analyte chimique et/ou de plusieurs analytes chimiques (11).

3. Appareil (1) selon l'une quelconque des revendications précédentes, comprenant une pluralité de transistors à effet de champ à base de graphène (3).

4. Appareil (1) selon la revendication 3, dans lequel différents transistors à effet de champ à base de graphène (3) sont configurés pour fournir différentes réponses à des impulsions de rayonnement électromagnétique (9) lorsque l'appareil est exposé à l'échantillon (11).

5. Appareil (1) selon l'une quelconque des revendications 3 et 4, dans lequel différents transistors à effet de champ à base de graphène (3) présentent : différents types de points quantiques et/ou différents types de ligands et/ou différentes épaisseurs.

6. Appareil (1) selon l'une quelconque des revendications précédentes, comprenant un émetteur (13) configuré pour fournir des impulsions de rayonnement électromagnétique (9).

7. Appareil (1) selon la revendication 6, dans lequel l'émetteur (13) est configuré pour permettre la commande : d'une longueur d'onde et/ou d'une puissance et/ou d'une durée de l'impulsion de rayonnement électromagnétique (9) et/ou d'une fréquence de répétition d'impulsions de l'impulsion de rayonnement électromagnétique (9).

8. Appareil (1) selon l'une quelconque des revendications 6 et 7, dans lequel l'émetteur (13) est configuré pour fournir une première impulsion de rayonnement électromagnétique (9) qui présente une première longueur d'onde à un premier moment pour déclencher une réaction photochimique, et une seconde impulsion de rayonnement électromagnétique (9) qui présente une seconde longueur d'onde, différente de la première longueur d'onde, à un second moment pour obtenir une réponse en provenance du transistor à effet de champ à base de graphène (3).

9. Appareil (1) selon l'une quelconque des revendications précédentes, comprenant un photodétecteur (51) couplé à une électrode grille d'un transistor à effet de champ à base de graphène (3) à l'intérieur de l'appareil (1).

10. Appareil (1) selon l'une quelconque des revendications précédentes, comprenant un ensemble de circuits pour surveiller des paramètres de la réponse du transistor à effet de champ à base de graphène (3), dans lequel les paramètres comprennent : l'amplitude et/ou la constante de temps de réponse et/ou le temps de reprise et/ou la constante de temps de reprise.

11. Appareil (1) selon l'une quelconque des revendications précédentes, comprenant au moins un capteur de température.

12. Appareil (1) selon l'une quelconque des revendications précédentes, comprenant au moins un capteur de pression.

**13.** Dispositif de détection comprenant un appareil (1) selon l'une quelconque des revendications 1 à 12.

**14.** Procédé comprenant :

l'exposition d'un transistor à effet de champ à base de graphène (3) à un échantillon (11) comprenant un ou plusieurs analytes chimiques, dans lequel le transistor à effet de champ à base de graphène (3) comprend une électrode source (21) et une électrode drain (23), dans lequel un canal de graphène (5) est disposé entre l'électrode source (21) et l'électrode drain (23), dans lequel des points quantiques (7) sont couplés au canal de graphène (5), dans lequel les points quantiques (7) sont configurés pour réaliser la fonction d'une électrode grille en régulant la circulation d'un courant à travers le canal de graphène entre l'électrode source et l'électrode drain ; et dans lequel un ligand est couplé aux points quantiques ;
dans lequel le ou les analytes chimiques interagissent avec les points quantiques et/ou le ligand ;
l'éclairage du transistor à effet de champ à base de graphène (3) par une impulsion de rayonnement électromagnétique (9) de telle sorte que la sortie électronique fournie par le transistor à effet de champ à base de graphène (3), à la suite de l'impulsion de rayonnement électromagnétique (9), soit dépendante d'un analyte chimique et/ou de plusieurs analytes chimiques dans l'échantillon (11).

FIG. 1

FIG. 2

FIG. 3

EXPOSE FIELD EFFECT
TRANSISTOR TO SAMPLE — 41

ILLUMINATE WITH PULSE
OF EM RADIATION — 43

FIG. 4

FIG. 5A

FIG. 5B

FIG. 5C

FIG. 6A

FIG. 6B

FIG. 6C

FIG. 6D

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012154726 A


**Non-patent literature cited in the description**

- **XIAORU ZHANG et al.** *CHEMICAL COMMUNICATIONS,* 01 January 2011, vol. 47 (17), 4929
- **WEN GUANGMING et al.** SCIENCE CHINA CHEMISTRY. ZHONGGUO KEXUE ZAZHISHE/SPRINGER, 15 March 2015, vol. 58, 879-884
- **GERASIMOS KONSTANTATOS et al.** *NATURE NANOTECHNOLOGY,* 01 January 2012, vol. 7 (6), 363-368
- **SHIXING CHEN et al.** *THE ANALYST,* 01 January 2015, vol. 140 (19), 6439-6451